# EUROPEAN PATENT APPLICATION

(11) **EP 4 675 925 A1**
(43) Date of publication of application: **07.01.2026**
(21) Application number: 24797293.8
(22) Date of filing: 30.03.2024
(51) Int. Cl.: H03K 17/945, B66B 1/46

(54) **TOUCHLESS BUTTON SYSTEM**

(30) Priority: 27.04.2023 KR 20230055235
(71) Applicant: Ilion Co., Ltd., Goyang city Gyeonggi-do 10442 (KR); Shin, Kyong Min, Goyang city Gyeonggi-do 10442 (KR)
(72) Inventor: BYUN, Hoonsuk, Goyang city Gyeonggi-do 10417 (KR)
(74) Representative: De Vries & Metman
(86) International application number: PCT/KR2024/004123
(87) International publication number: WO 2024/225631

(57) **Abstract**

The present invention relates to a touchless button system. The system comprises a plurality of buttons, a distance sensor disposed between the plurality of buttons, the distance sensor facing a push direction of the buttons and having a plurality of sensing areas, and a control unit configured to select one button among the plurality of buttons using information regarding an object detected by the distance sensor. The touchless button system according to the present invention has advantages of high object recognition accuracy while having low installation cost.

## Description

### FIELD OF THE INVENTION

The present invention relates to a touchless button system, and more particularly, to a touchless button system equipped with ToF (Time of Flight) sensors.

### BACKGROUND ART

Elevators are installed in high-rise buildings such as buildings and apartments to facilitate vertical movement. Users who board an elevator typically move to their destination floor or open and close the elevator doors by pressing elevator touch buttons with floor numbers displayed with their fingers.

Conventional elevator touch buttons are push-type or capacitive-type that detect changes in capacitance, but in any case, finger contact with the button is required. Recently, hygiene has been considered an important issue in public facilities, and methods to minimize contact with hands, which contain many contaminants, are being studied. Therefore, to reduce the spread of infectious diseases by elevator touch buttons installed in subway stations, airports, hospitals, etc., structures that can register destination floors by touchless methods and can be easily applied to already installed elevators are being proposed.

One method for implementing a touchless (or non-touch) button system with high sensing accuracy is to use ToF (Time of Flight) sensors. However, the structure of applying ToF sensors to each elevator button has the problem of requiring replacement of existing buttons.

### DETAILD DESCRIPTION OF THE INVENTION

### TECHNICAL PROBLEM

Therefore, the present invention aims to provide a touchless button system equipped with ToF sensors that has high sensing accuracy while having low installation cost.

### TECHNICAL SOLUTION

The present invention, for solving the above purpose, provides, as one feature, a touchless button system comprising: a plurality of buttons; a distance sensor disposed between the plurality of buttons, the distance sensor facing a push direction of the buttons and having a plurality of sensing areas; and a control unit configured to select one button among the plurality of buttons using information regarding an object detected by the distance sensor.

Preferably, the control unit is configured to select a button according to a sensing area having distance information that indicates the closest distance to the object. In addition, the control unit may be configured to select a button only when the distance to the object changes to become sequentially shorter.

Preferably, the control unit may be configured to ignore an approach of the object such that button selection is not performed when the object approaches a sensing area corresponding to a front side of the distance sensor.

Preferably, the control unit may be configured to select a button according to a change in a direction of the sensing area in which the object is detected.

### TECHNICAL EFFECTS

According to the present invention having the above-described configuration, the touchless button system equipped with distance sensors has advantages of high object recognition accuracy while having low installation cost.

### BRIEF DESCRIPTION OF THE DRAWINGS

FIG. 1 illustrates the configuration and operation of a touchless button system according to an embodiment of the present invention.
FIG. 2 is a detailed configuration diagram of the distance measurement unit shown in FIG. 1.
FIG. 3 is a configuration diagram of the ToF (Time of Flight) sensor shown in FIG. 2.
FIG. 4 illustrates in detail the operation of the touchless button system shown in FIG. 1 when an object approaches normally.
FIG. 5 illustrates the operation of the touchless button system shown in FIG. 1 when an object having a wide area approaches.
FIG. 6 illustrates the operation according to the movement direction of an object in the touchless button system shown in FIG. 1.
FIG. 7 illustrates the configuration and operation of a touchless button system according to another embodiment of the present invention.

### BEST MODE FOR ACCOMPLISHING THE INVENTION

To fully understand the present invention, preferred embodiments of the present invention will be described with reference to the accompanying drawings. The embodiments of the present invention may be modified in various forms, and the scope of the present invention should not be construed as being limited to the embodiments described in detail below. The present embodiment is provided to more completely explain the present invention to those having ordinary knowledge in the art. Therefore, the shapes of elements in the drawings may be exaggerated to emphasize clearer description. It should be noted that the same members in each drawing may be shown with the same reference numerals. Detailed descriptions of known functions and configurations that may unnecessarily obscure the subject matter of the present invention are omitted.

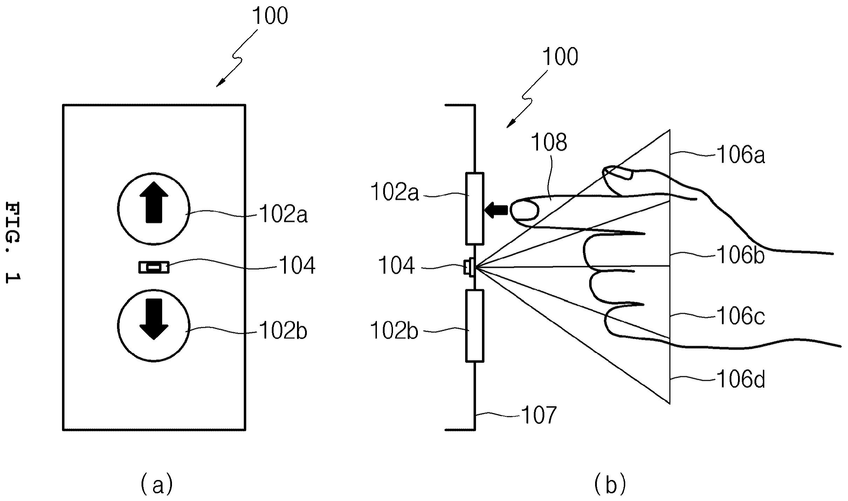

FIG. 1 is a diagram illustrating the configuration and operation of a touchless button system 100 according to an embodiment of the present invention, where FIG. 1(a) is a front view and FIG. 1(b) is a side view. As shown, the touchless button system 100 comprises a plurality of (two as an example) buttons 102a, 102b and a distance measurement unit 104. The distance measurement unit 104 comprises a ToF sensor as a distance sensor and a control unit for button selection, as described in detail below.

The ToF sensor is installed between the buttons 102a, 102b to face the push direction of the buttons 102a, 102b (indicated by arrows in FIG. 1). Also, the ToF sensor is installed to have a plurality of sensing areas 106a, 106b, 106c, 106d perpendicular to the push direction in front of a surface 107 where the plurality of buttons 102a, 102b are installed. The ToF sensor can generate information about the distance to an object 108 located in the sensing areas 106a, 106b, 106c, 106d as well as information about the sensing area where the object is located.

As the ToF sensor, a multi-zone ToF sensor having a plurality of sensing areas adjacent in a lateral direction may be used. The multi-zone ToF sensor can recognize not only the distance to an object but also the sensing area where the object exists.

When an object 108 approaches to select a specific button of the touchless button system 100, the ToF sensor of the distance measurement unit 104 transmits information about the distance to the object 108 and information about the sensing area where the object 108 is located to the control unit. The control unit operates so that one button among the plurality of buttons 102a, 102b is selected from the distance information and sensing area information transmitted from the ToF sensor. The control unit maps sensing area 106a to button 102a and maps sensing area 106d to button 102b. In the case of object 108 shown in FIG. 1, although object 108 exists in all sensing areas 106a, 106b, 106c, 106d, since the distance to object 108 in sensing area 106a is closest to the distance measurement unit 104, the control unit operates so that the upper button 102a is selected.

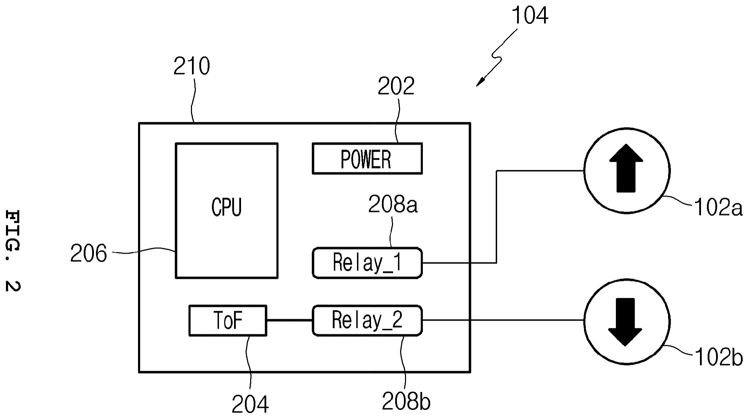

FIG. 2 is a detailed configuration diagram of the distance measurement unit 104 shown in FIG. 1. As shown, the distance measurement unit 104 comprises a power supply unit 202, control unit 204, ToF sensor 206, relays 208a, 208b, and circuit board 210.

The power supply unit 202 receives power from outside and converts it to power for driving the distance measurement unit 104. The ToF sensor 204 is a distance sensor that senses the distance to objects within the sensing area. The control unit 206 determines the selected button from the distance sensed by the ToF sensor 204, generates a control signal according to the determination result, and provides it to the selected relay. When a control signal is provided from the control unit 206, relay 208a causes button 102a to be selected, and relay 208b causes button 102b to be selected. The circuit board 210 provides electrical connections between the components 202, 204, 206, 208a, 208b.

The touchless button system 100 according to this embodiment is easy to install and has low installation cost since only the distance measurement unit 104 needs to be installed in an existing button system.

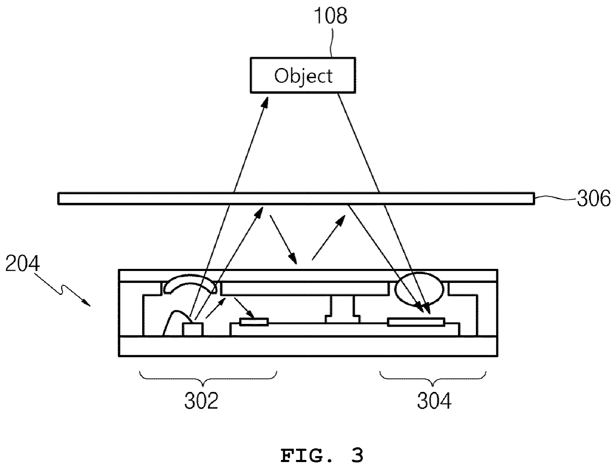

FIG. 3 is a configuration diagram of the ToF (Time of Flight) sensor shown in FIG. 2. As shown, the ToF sensor 204 comprises a transmitting unit 302 and receiving unit 304. For example, the transmitting unit consists of a VCSEL (Vertical Cavity Surface Emitting Laser), and the receiving unit consists of a SPAD (Single Photon Avalanche Diode). The distance measurement unit 104 may comprise a glass plate 306 etc. in front of the ToF sensor 204 to prevent contamination or damage of the ToF sensor 204.

The transmitting unit 302 transmits infrared light, and the receiving unit 304 receives reflected infrared light. For example, the FOI (Field of illumination) of the transmitting unit 302 is approximately 40 degrees, and the FOV (Field of View) of the receiving unit 304 is 30 to 60 degrees in the Y-axis direction and 30 to 42 degrees in the X-axis direction. The ToF sensor 204 measures the distance to the object 108 by measuring the time from when infrared light is transmitted from the transmitting unit 302 to when the signal reflected from the object 108 is received by the receiving unit 304.

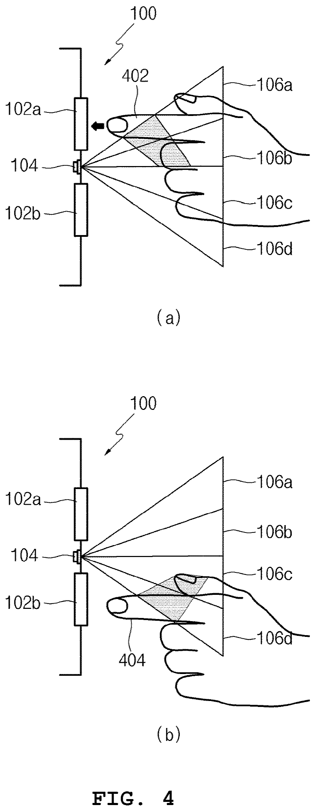

FIG. 4 is a diagram illustrating in detail the operation of the touchless button system 100 shown in FIG. 1 when objects 402, 404 approach normally, where FIG. 4(a) shows the case when object 402 is directed toward the upper button 102a and FIG. 4(b) shows the case when object 404 is directed toward the lower button 102b.

As shown in FIG. 4(a), when object 402 is a hand with a protruding index finger and the index finger is directed toward the upper button 102a, object 402 is sensed in all sensing areas 106a, 106b, 106c, 106d. The distance to object 402 detected by the distance measurement unit 104 is closest in sensing area 106a, similar in sensing areas 106b, 106c, and farthest in sensing area 106d. In this case, the control unit operates so that the upper button 102a mapped to sensing area 106a is selected.

As shown in FIG. 4(b), when object 404 is a hand with a protruding index finger and the index finger is directed toward the lower button 102b, object 404 is sensed in some sensing areas 106c, 106d. The distance to object 404 detected by the distance measurement unit 104 is relatively far in sensing area 106c and relatively close in sensing area 106d. In this case, the control unit operates so that the lower button 102b mapped to sensing area 106d is selected.

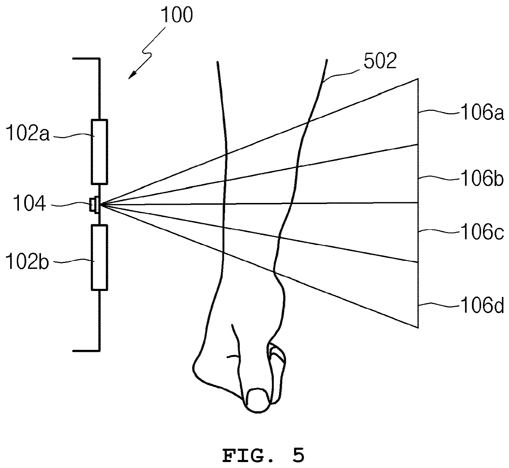

FIG. 5 illustrates the operation of the touchless button system 100 shown in FIG. 1 when an object 502 having a wide area approaches.

When object 502 shown in FIG. 5 approaches the touchless button system 100, object 502 is sensed in all sensing areas 106a, 106b, 106c, 106d. The distance to object 502 detected by the distance measurement unit 104 is relatively far in sensing areas 106a, 106d and relatively close in sensing areas 106b, 106c. Sensing areas 106b, 106c are located directly in front of the distance measurement unit 104 (i.e., ToF sensor), and the distance measurement unit 104 is located between buttons 102a, 102b. When the closest distance is detected in sensing areas 106b, 106c corresponding to directly in front of the distance measurement unit 104, the control unit may ignore the approach of object 502 since it is difficult to specify a button. Also, when the distance detected in sensing area 106a mapped to button 102a and the distance detected in sensing area 106d mapped to button 102b are approximately similar and the distance difference is small, the control unit may ignore object 502 since it is difficult to specify the selected button.

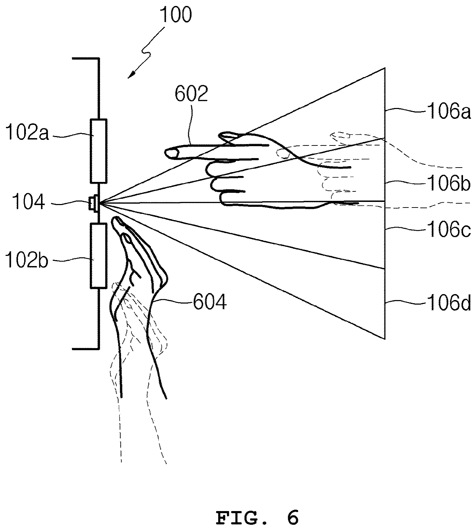

FIG. 6 illustrates the operation according to the movement direction of objects 602, 604 in the touchless button system 100 shown in FIG. 1.

In the case of object 602, the closest distance is detected in sensing area 106a, and the distance to object 602 in sensing area 106a gradually changes in a direction of becoming closer for a predetermined time during the button selection process. When the distance to the object changes to become sequentially closer in the sensing area where the closest distance is detected, the control unit determines the movement of object 602 as a normal button selection process and causes a specific button to be selected.

When object 604 moves like the hand of a visually impaired person groping to find Braille, the closest distance is detected in sensing area 106d, but a gradual change in distance over a predetermined time is not detected in sensing area 106d. In this case, the control unit of the distance measurement unit 104 ignores object 604 so that button selection by touchless is not performed and button selection is performed only by touch.

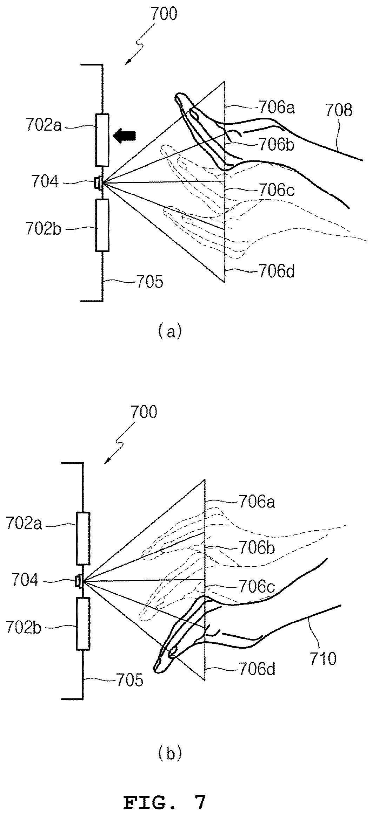

FIG. 7 is a diagram illustrating the configuration and operation of a touchless button system 700 according to another embodiment of the present invention, where FIG. 7(a) shows the case when object 708 moves upward and FIG. 7(b) shows the case when object 710 moves downward. As shown, the touchless button system 700 comprises a plurality of (two as an example) buttons 702a, 702b and a distance measurement unit 704. The distance measurement unit 704 comprises a ToF sensor and control unit as described in detail in relation to the distance measurement unit 104.

The ToF sensor is installed between the buttons 702a, 702b to face the push direction of the buttons 702a, 702b (indicated by arrows in FIG. 7). Also, the ToF sensor is installed to have a plurality of sensing areas 706a, 706b, 706c, 706d perpendicular to the push direction in front of a surface 705 where the plurality of buttons 702a, 702b are installed. The ToF sensor can generate information about the distance to objects 708, 710 located in the sensing areas 706a, 706b, 706c, 706d as well as information about the sensing area where the objects are located.

As shown in FIG. 7(a), when object 708 moves upward to select a specific button of the touchless button system 700, the sensing area where the shortest distance to object 708 is sensed changes in the direction of 706d → 706c → 706b → 706a. In this case, the control unit operates so that the upper button 702a is selected. As shown in FIG. 7(b), when object 710 moves downward, the sensing area where the shortest distance to object 710 is sensed changes in the direction of 706a → 706b → 706c → 706d. In this case, the control unit operates so that the lower button 702b is selected. In this way, the control unit can determine the user's gesture by the change direction of the sensing area to perform button selection.

Although not shown, overall power consumption can be reduced by having a separate sensor with a long recognition distance to determine the presence of objects and controlling the position recognition ToF sensor installed on the button to be in a low power state when the presence of objects is not detected.

The embodiments of the present invention described above are merely exemplary, and those having ordinary knowledge in the art to which the present invention belongs will be able to understand that various modifications and equivalent other embodiments are possible therefrom. Therefore, it will be well understood that the present invention is not limited only to the forms mentioned in the detailed description above. Therefore, the true technical protection scope of the present invention should be determined by the technical spirit of the appended claims. Also, the present invention should be understood to include all modifications, equivalents, and substitutes within the spirit and scope of the present invention defined by the appended claims.

## Claims

1. A touchless button system comprising:
a plurality of buttons;
a distance sensor disposed between the plurality of buttons, the distance sensor facing a push direction of the buttons and having a plurality of sensing areas; and
a control unit configured to select one button among the plurality of buttons using information regarding an object detected by the distance sensor.

2. The touchless button system of claim 1, wherein the control unit is configured to cause a button to be selected when a distance to the object changes to become sequentially shorter.

3. The touchless button system of claim 1, wherein the control unit is configured to ignore an approach of the object when the object approaches a sensing area corresponding to a front side of the distance sensor.

4. The touchless button system of claim 1, wherein the control unit is configured to select a button according to a change in a direction of a sensing area in which the object is detected.
